Europäisches Patentamt

European Patent Office

Office européen des brevets

(19)

(11) Publication number : **0 508 707 A1**

## (12) EUROPEAN PATENT APPLICATION

(21) Application number : 92303026.6

(22) Date of filing : 06.04.92

(51) Int. Cl.⁵ : **G01R 31/28, G01R 1/073**

(30) Priority : **12.04.91 US 685308**

(43) Date of publication of application :
**14.10.92 Bulletin 92/42**

(84) Designated Contracting States :
**DE FR GB IT NL**

(71) Applicant : **TEXAS INSTRUMENTS
INCORPORATED
13500 North Central Expressway
Dallas Texas 75265 (US)**

(72) Inventor : **Wright, Fred J.
125 Wagonwheel
Wylie, Texas 75098 (US)**

(74) Representative : **Blanco White, Henry Nicholas
et al
ABEL & IMRAY Northumberland House
303-306 High Holborn
London WC1V 7LH (GB)**

(54) **System for testing on-wafer devices.**

(57)    A test system for testing semiconductor devices on a semiconductor wafer using a flexible membrane probe includes, a test system computer ; at least one test head (12, 13) connected to the test system computer ; and at least one test probe (18, 19, 20, 21), connected to the test head, the test probe having a plurality of flexible membranes (22, 23, 24, 25) with a number of contacts thereon in number equal to the number of contacts on all the devices on the semiconductor wafer.

FIGURE 1

EP 0 508 707 A1

## FIELD OF THE INVENTION

This invention relates to semiconductor devices, and more particularly to a system for testing semiconductor prior to separation from the semiconductor wafer.

## CROSS REFERENCED INVENTION

This invention uses technology similar, in part, to copending patent application Serial No.       , filed April                  , 1990, entitled PROBE CARD FOR TESTING OF SEMICONDUCTOR DEVICES (TI14159).

## BACKGROUND OF THE INVENTION

Integrated circuits, Hybrid devices and packaging interconnects are all increasing in size and complexity. Large area devices and substrates with high I/O pin counts are becoming more common. One problem with large devices is that it is becoming more difficult to electrically test the circuits. As the density and number of I/O on a circuit increase, conventional probe cards become more difficult to construct and maintain. For large ASIC devices, the number of I/O pads may exceed the maximum density of probes which can be accommodated on a conventional probe card. With some applications, such as probing hybrid substrates or packaging interconnects, an area array of probe locations would be desirable, nut impossible to test with current technology. In addition to these problems of probe card complexity, the cost of a probe card increases dramatically as the prone count increases.

Standard electrical probing methods for semiconductor devices utilize needle or "blade" probe cards to provide electrical contact between the test system and the device. Tungsten needles are soldered onto an epoxy board around the perimeter of a hole cut in the probe card. The fabrication of these probe cards is more of an art than a manufacturing technique in that each probe point must be individually soldered to the card, and carefully aligned to a test pad on the device. The planarity and relative position of the needle tips are critical to successful probing of a device. During use, each contact of the probe tips to the test pads causes the needles to be slightly deformed, eventually resulting in the probe card needing repair. This labor intensive method of making and maintaining probe cards causes the price of the card to be high, increasing in cost as the number of probe tips increase.

There have been some test heads made using a flexible membrane for testing single semiconductor die. Considering that a semiconductor wafer may have between 200 and 300 individual die, the time to test each die individually is time consuming.

## SUMMARY OF THE INVENTION

The invention is to a system and apparatus for testing semiconductor devices at the wafer level. The system uses a flexible probe having a contact pattern the same as the contact pattern on all the devices on the wafer. The probe includes multi-layers of flexible membrane with interconnection conductors on the layers that are connected to each contact of the contact pattern. The conductors are connected to a pin electronic test head that is used to provide test signals and voltages to the devices under test. The test head is connected to a test system that may be self-contained or connected to a mainframe test system.

The technical advance represented by the invention as well as the objects thereof will become apparent from the following description of a preferred embodiment of the invention when considered in conjunction with the accompanying drawings, and the novel features set forth in the appended claims.

## BRIEF DESCRIPTION OF THE DRAWINGS

FIGURE 1 illustrates a block diagram of a test system using multiple probe cards; and
FIGURE 2 illustrates a wafer level probe card.
FIGURE 3 is a partial cross section view of the probe card of Figure 2.

## DESCRIPTION OF A PREFERRED EMBODIMENT OF THE INVENTION

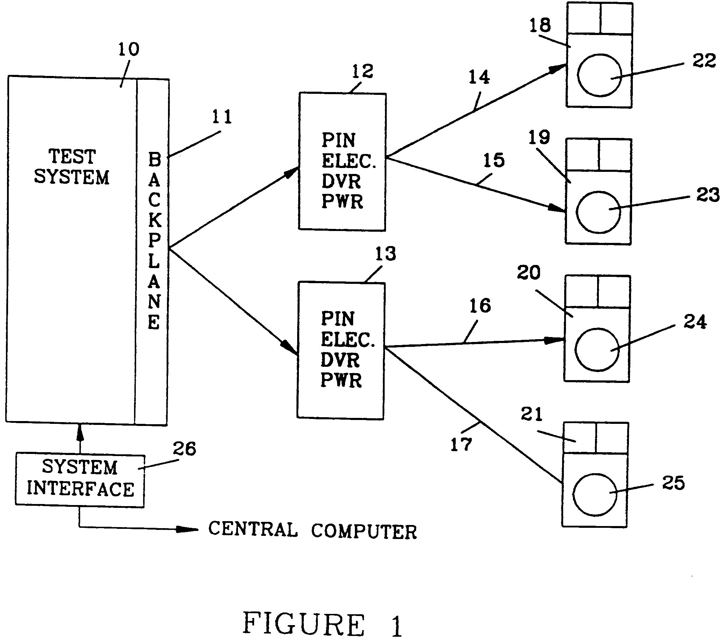

Figure 1 illustrates a test system for testing multiple wafers and testing each semiconductor device prior to separation from the wafer. Test system 10 has a backplane 11 that is interconnected to two test heads 12 and 13. Each test head has the pin electronics capable of sending test signals and voltages to a wafer probe. Test head 12 is connected to probe cards 18 and 19. by cables 14 and 15 respectively. Each test probe, 18 and 19, has a flexible membrane 22, 23 that has the same number of contacts thereon as the number of contacts for all the devices on a wafer under test.

Test head 13 has two probe test cards 20 and 21 connected by cables 16 and 17 , respectively. Test probe cards 20 and 21 each have the flexible membranes 24 and 25 which also have a contact pattern thereon. With the test system illustrated, four wafers may be test at one time. Four is not a limitation. The only limitation is the number of pin electronics and test probe card in the system.

Test system 10 may be a dedicated test system or may interface to a central computing system. An interface 26 is shown connecting the test system to a central computer system.

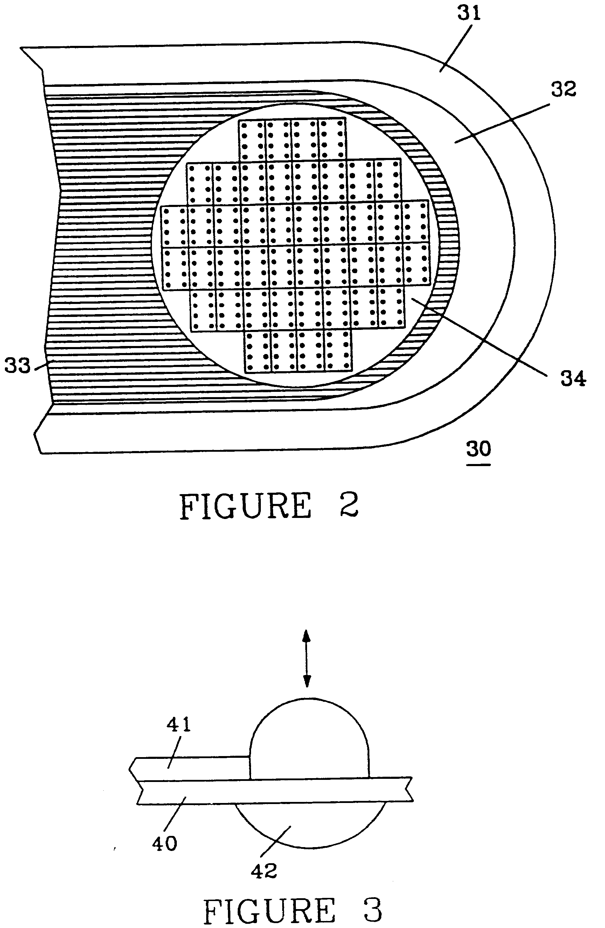

Figure 2 illustrates a test probe card having a support member 31 holding membrane 32. Membrane 32 has an array of contacts 34 pattern the same as the contacts as the semiconductor wafer to be tested. Connected to the contacts are conductors 33. There is one conductor for each contact. The conductors are connected to a test head. Within the test head, the conductors may be multiplexed so that a set of pin electronic may be used to test a plurality of devices.

Flexible membrane 32 is actually several layers, each layer having a plurality of conductors 33 thereon. Several layers are necessary to provide for the number of conductors required. The flexible material may be, for example, polyimide.

Figure 3 shows a layer of membrane 40 with a conductor trace 41 thereon and a bump contact 42. Since membrane 40 is free to flex around each contact 42, any non-planarity in a contact on the wafer is compensated.

In operation, a probe test card is brought into engagement with a semiconductor wafer, each contact on the probe card engaging a respective contact on a device on the wafer. Downward pressure is exerted on the support member 31 to engage the contacts on the probe card with the contacts on the wafer. Because the membrane on which the probe card contacts resides is flexible, contact will be made between all the contacts on the probe card and all the contacts on the wafer.

Each device on the wafer under goes a series of test as determined by the test system 10, and as interconnected by the tests heads 12 and 13. Each test head supplies the required voltages and signals for testing at least two probe test cards. Multiple test heads provide the capability to test a plurality of wafers at one time.

## Claims

1. A test system for testing semiconductor devices on a semiconductor wafer using a flexible membrane probe, comprising:
   a test system computer;
   at least one test head connected to the test system computer; and
   at least one test probe, connected to the test head, the test probe having a flexible membrane with a number of contacts thereon in number equal to the number of the contacts on all the devices on the semiconductor wafer.

2. The test system according to claim 1, wherein the flexible membrane is a multi-layer membrane having conductors on each layer for interconnecting the contacts on the membrane with the at least one test head.

3. The test system according to claim 1, wherein the pattern for the contacts on the test probe is the same pattern as all the contacts on the semiconductor wafer being tested.

4. The test system according to claim 1, wherein the test probe has a frame extending at least partially around the flexible membrane to apply a positive downward pressure to the flexible membrane to engage all the contacts on the membrane with all the contacts on all the devices on the semiconductor wafer under test.

5. The test system according to claim 1, wherein the test head multiplexes test signals and voltages from the test system computer to the conductors on the test probe.

6. A test system for testing semiconductor devices on a semiconductor wafer using a flexible membrane probe, comprising:
   a test system computer;
   at least one test head connected to the test system computer; and
   at least one test probe, connected to the test head, the test probe having a plurality of flexible membranes with a number of contacts thereon in number equal to the number of contacts on all the devices on the semiconductor wafer.

7. The test system according to claim 6, wherein the multilayer flexible membrane has conductors on each layer for interconnecting the contacts on :he membrane with the at least one test head.

8. The test system according to claim 6, wherein the pattern for the contacts on the test probe is the same pattern as all the contacts on the semiconductor wafer being tested.

9. The test system according to claim 6, wherein the test probe has a frame extending at least partially around the flexible membrane to apply a positive downward pressure to the flexible membrane to engage all the contacts on the membrane with all the contacts on all the devices on the semiconductor wafer under test.

10. The test system according to claim 6, wherein the test head multiplexes test signals and voltages from the test system computer to the conductors on the test probe.

FIGURE 1

FIGURE 2

FIGURE 3

**European Patent Office**

# EUROPEAN SEARCH REPORT

Application Number

EP     92 30 3026
PAGE 1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | WO-A-8 911 659 (G.J.LEEDY)<br>* abstract; figure 5 *<br>* page 5, line 10 - line 21 *<br>* page 16, line 5 - page 17, line 12 * | 1-10 | G01R31/28<br>G01R1/073 |
| X,P | US-A-5 012 187 (H.W.LITTLEBURY)<br>* abstract; figure 2 *<br>* column 1, line 22 - line 27 *<br>* column 3, line 55 - line 59 * | 1,6 | |
| Y | US-A-4 968 931 (H.W.LITTLEBURY ET AL.)<br>* abstract; figures 3,5,2 *<br>* column 4, line 54 - line 68 * | 1,6 | |
| Y | US-A-4 985 988 (H.W.LITTLEBURY)<br>* abstract *<br>* column 2, line 41 - line 63 *<br>* column 3, line 12 - line 36 * | 1,6 | |
| A | GB-A-1 104 090 (IBM)<br>* page 1, line 45 - line 61; figure 4 *<br>* page 3, line 1 - line 21 *<br>* page 4, line 8 - line 20 * | 1-10 | **TECHNICAL FIELDS SEARCHED (Int. Cl.5)** |
| A | EP-A-0 230 348 (HEWLETT-PACKARD)<br>* abstract *<br>* page 2, line 24 - page 3, line 10 *<br>* page 4, line 35 - page 5, line 6 *<br>* page 7, line 29 - page 8, line 4 *<br>* page 10, line 14 - line 20 * | 1-10 | G01R<br>G06F |
| A | US-A-4 922 192 (H.D.GROSS ET AL.)<br>* abstract; figure 3 * | 1-10 | |
| A | US-A-4 972 143 (A.KAMENSKY ET AL.)<br>* abstract *<br>* column 3, line 54 - line 61 * | 1,6 | |

-/--

The present search report has been drawn up for all claims

| Place of search | Date of completion of the search | Examiner |
|---|---|---|
| BERLIN | 11 JUNE 1992 | S.C.Fritz |

EPO FORM 1503 03.82 (P0401)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**European Patent Office**

# EUROPEAN SEARCH REPORT

Application Number

EP 92 30 3026
PAGE2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | US-A-4 639 664 (A.M.CHIU ET AL.) <br> * abstract; figure 1 * <br> * column 3, line 11 - line 20 * <br> --- | 1,6 | |
| A | DE-A-3 637 502 (MBB) <br> * abstract; claim 1; figures 1-3 * <br> --- | 1,6 | |
| A | PATENT ABSTRACTS OF JAPAN <br> vol. 14, no. 550 (E-1009)6 December 1990 <br> & JP-A-2 237 047 ( MITSUBISHI ELECTRIC ) 19 September 1990 <br> & US-A-5 055 780 <br> * abstract * <br> ----- | 1,6 | |
| | | | TECHNICAL FIELDS SEARCHED (Int. Cl.5 ) |

The present search report has been drawn up for all claims

| Place of search | Date of completion of the search | Examiner |
|---|---|---|
| BERLIN | 11 JUNE 1992 | S.C.Fritz |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)